# EUROPEAN PATENT APPLICATION

(11) **EP 4 807 378 A1**
(43) Date of publication of application: **16.09.2026**
(21) Application number: 26158517.8
(22) Date of filing: 13.02.2026
(51) Int. Cl.: G01R 31/327

(54) **CONTACTOR LIFETIME PREDICTION APPARATUS AND METHOD, AND BATTERY PACK**

(30) Priority: 12.03.2025 KR 20250032318
(71) Applicant: SAMSUNG SDI CO., LTD., Yongin-si, Gyeonggi-do 17084 (KR)
(72) Inventor: KIM, Suk Ki, 16678 Suwon-si (KR); KIM, Woo Choul, 16678 Suwon-si (KR)
(74) Representative: Maiwald GmbH

(57) **Abstract**

A contactor lifetime prediction apparatus includes a measurement circuit configured to measure a current flowing in a contactor, and a processor configured to calculate a number of cycles of the contactor based on the current measured by the measurement circuit when the contactor is turned on or off, to accumulate the calculated number of cycles, and to predict a lifetime of the contactor.

## Description

### BACKGROUND

### 1. Field

Aspects of the present disclosure relate to a contactor lifetime prediction apparatus a method of using the same, and a battery pack.

### 2. Description of the Related Art

Recently, as the demand for portable electronic products such as notebooks, video cameras, and portable phones is rapidly increasing, and the development of electric vehicles, energy storage batteries, robots, satellites, and the like are beginning in earnest, research on high-performance secondary batteries that are repeatedly chargeable/dischargeable is being actively conducted.

Currently commercialized secondary batteries include nickel cadmium batteries, nickel hydrogen batteries, nickel zinc batteries, and lithium secondary batteries. Among these, lithium secondary batteries are receiving attention due to advantages of being easily charged or discharged, having a very low self-discharge rate, and having high energy density due to the almost complete absence of memory effects in comparison to nickel-based secondary batteries.

The secondary battery is sometimes formed of a single battery cell, but is often formed of a battery pack in which a plurality of battery cells are connected in series and/or in parallel for use in high-voltage and/or large-capacity power storage systems.

Battery packs are installed in electric vehicles (EVs), hybrid electric vehicles (HEVs), and electric storage systems (ESSs) to supply power to loads such as electric motors and inverters.

In general, a contactor (including a relay, a switch, or the like) is installed on a power supply line between a battery pack and a load, and the contactor selectively performs a function of forming a closed circuit. Like other common devices, as contactors are being used, a lifetime (e.g., lifespan) thereof is shortened. Contactor manufacturers sometimes provide warranty periods for contactors, but a lifetime of a contactor may not be determined uniformly and may vary according to a use state, which makes it difficult to evaluate the lifetime of the contactor based on only a warranty period.

The above information disclosed in this Background section is for enhancement of understanding of the background of the present disclosure, and therefore, it may contain information that does not constitute related (or prior) art.

### SUMMARY

Aspects of the present disclosure are directed to a contactor lifetime prediction apparatus and method of operating the same which allow a lifetime (e.g., lifespan) of a contactor to be predicted according to an actual use state of the contactor constituting a battery pack, and a battery management system.

However, objects that the present disclosure intends to achieve are not limited to the above-described objects and other objects that are not described may be clearly understood by those skilled in the art from the following description.

According to an aspect of the present disclosure, there is provided a contactor lifetime prediction apparatus including: a measurement circuit configured to measure a current flowing in a contactor; and a processor configured to calculate a number of cycles of the contactor based on the current measured by the measurement circuit when the contactor is turned on or off, to accumulate the calculated number of cycles, and to predict a lifetime of the contactor.

In some embodiments, the processor is configured to calculate the number of cycles of the contactor using an exponential function in which the number of cycles decreases as a current value increases.

In some embodiments, the processor is configured to predict the lifetime of the contactor after comparing the accumulated number of cycles with a reference number of cycles.

In some embodiments, the processor is configured to calculate a percentage of a ratio of the accumulated number of cycles to the reference number of cycles, and to predict that a remaining lifetime of the contactor is a remaining percentage relative to the calculated percentage.

In some embodiments, the contactor lifetime prediction apparatus further includes an alarm circuit, wherein, in response to the accumulated number of cycles being greater than or equal to a threshold number of cycles, the processor is configured to output an alarm signal through the alarm circuit.

In some embodiments, in response to the current measured through the measurement circuit at a time point at which the contactor is turned off being greater than or equal to a maximum allowable current value, the processor is configured to output the alarm signal through the alarm circuit.

According to an aspect of the present disclosure, there is provided a contactor lifetime prediction method including: measuring, by a processor, a current flowing in a contactor when the contactor is turned on or off; calculating, by the processor, a number of cycles of the contactor based on the measured current; and accumulating, by the processor, the calculated number of cycles and predicting a lifetime of the contactor.

In some embodiments, in the calculating of the number of cycles of the contactor, the processor is configured to calculate the number of cycles of the contactor using an exponential function in which the number of cycles decreases as a current value increases.

In some embodiments, in the predicting of the lifetime of the contactor, the processor is configured to compare the accumulated number of cycles with a threshold number of cycles and to predict the lifetime of the contactor or to output an alarm signal according to a comparison result.

In some embodiments, in the predicting of the lifetime of the contactor, in response to the accumulated number of cycles is smaller than the threshold number of cycles, the processor is configured to predict the lifetime of the contactor after comparing the accumulated number of cycles with a reference number of cycles.

In some embodiments, in the predicting of the lifetime of the contactor, the processor is configured to calculate a percentage of a ratio of the accumulated number of cycles to the reference number of cycles, and to predict that a remaining lifetime of the contactor is a remaining percentage relative to the calculated percentage.

In some embodiments, in the predicting of the lifetime of the contactor, in response to the accumulated number of cycles being greater than or equal to the threshold number of cycles, the processor is configured to output the alarm signal.

In some embodiments, in the calculating of the number of cycles of the contactor, the processor is configured to compare the current, which is measured at a time point at which the contactor is turned off, with a maximum allowable current value and to calculate the number of cycles of the contactor or to output an alarm signal based on a comparison result.

In some embodiments, in the calculating of the number of cycles of the contactor, the processor is configured to calculate the number of cycles of the contactor based on the measured current in response to the current measured at the time point at which the contactor is turned off being smaller than the maximum allowable current value, and to output the alarm signal in response to the current measured at the time point at which the contactor is turned off being greater than or equal to the maximum allowable current value.

According to an aspect of the present disclosure, there is provided a battery pack including: a plurality of battery modules; a contactor directly or indirectly connected to the plurality of battery modules; and a battery management system

(BMS) configured to control an on/off operation of the contactor and to predict a lifetime of the contactor based on a current measured at a time point at which the contactor is turned on or off. The BMS includes: a measurement circuit configured to measure a current flowing in the contactor; and a processor configured to calculate a number of cycles of the contactor based on a current measured through the measurement circuit in response to the contactor being turned on or off, to accumulate the calculated number of cycles, and to predict a lifetime of the contactor

In some embodiments, the BMS further includes an alarm circuit, and in response to the accumulated number of cycles being greater than or equal to a threshold number of cycles, the processor is configured to output an alarm signal through the alarm circuit.

In some embodiments, in response to the current measured through the measurement circuit at the time point at which the contactor is turned off being greater than or equal to a maximum allowable current value, the processor is configured to output the alarm signal through the alarm circuit.

### BRIEF DESCRIPTION OF DRAWINGS

The following drawings attached to this specification illustrate embodiments of the present disclosure and further describe aspects and features of the present disclosure together with the detailed description of the present disclosure. Thus, the present disclosure should not be construed as being limited to the drawings:
FIG. 1 is a schematic diagram of a battery pack according to some embodiments of the present disclosure;
FIG. 2 is a schematic block diagram illustrating a configuration of a contactor lifetime prediction apparatus according to some embodiments of the present disclosure;
FIG. 3 is an exemplary graph for describing the number of cycles of a contactor according to a current value according to some embodiments of the present disclosure;
FIG. 4 is an exemplary graph for describing the trend of the current number of cycles according to a voltage change according to some embodiments of the present disclosure;
FIG. 5 is a flowchart for describing a contactor lifetime prediction method according to some embodiments of the present disclosure; and
FIG. 6 is a flowchart for describing a contactor lifetime prediction method according to some other embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or provided as a plurality.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

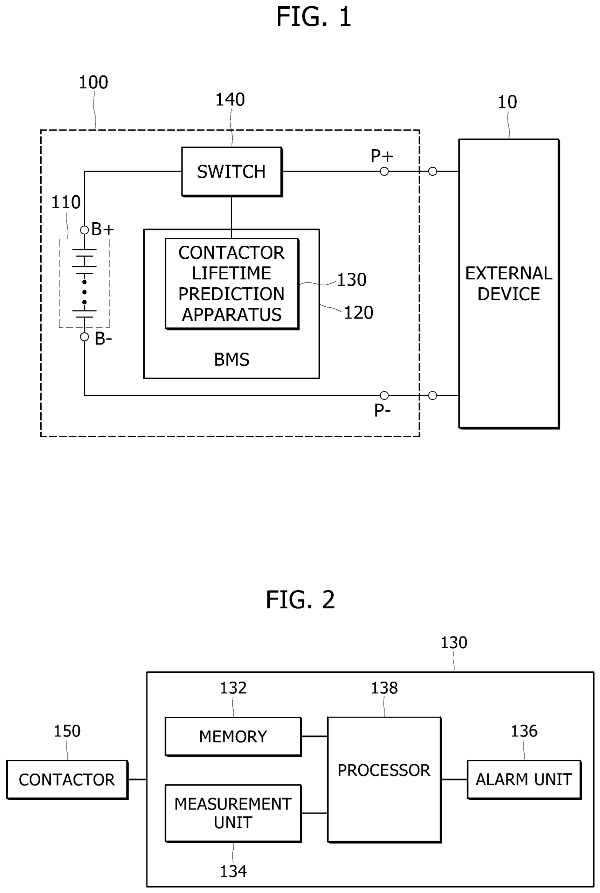

FIG. 1 is a schematic diagram of a battery pack according to some embodiments of the present disclosure.

Referring to FIG. 1, a battery pack 100 according to some embodiments of the present disclosure has a structure that may be electrically connected to an external device through a positive electrode connection terminal P+ and a negative electrode connection terminal P-.

An external device 10 may be a load (e.g., an electrical load) that receives power from the battery pack 100 or may be a charging device that supplies power to the battery pack 100 to charge a plurality of battery modules 110. When the external device is the load, the battery pack 100 operates as a power source supplying power to the load and is discharged. The external device 10 operating as the load may be, for example, an electronic device or a transportation device, and the transportation device may be, for example, an electric vehicle, a hybrid vehicle, or smart mobility.

The battery pack 100 may include at least one battery module 110, a switch 140, and a battery management system (hereinafter referred to as "BMS" 120). In various embodiments, it is apparent that the battery pack 100 may further include other suitable components.

The battery module 110 may include a plurality of cells connected in series, in parallel, or a combination of the two. The plurality of battery modules 110 may be connected in series, in parallel, or a combination of the two.

A switch 140 is connected to at least one of a plurality of pack terminals P+ and P- to block/allow electrical connection between the battery module 110 and the external device 10. The switch 140 may be installed on a current path for charging or discharging the battery module 110.

The switch 140 may control the electrical connection between the battery pack 100 and the external device 10. When the switch 140 is turned on (i.e., activated), the battery pack 100 and the external device may be electrically connected so that charging or discharging may be performed. When the switch 140 is turned off (i.e., deactivated), the battery pack 100 and the external device 10 may be electrically separated (i.e., electrically isolated or disconnected). That is, when the switch 140 is turned on, power may be supplied from the battery module 110 to the external device 10 or from the external device 10 to the battery module 110. While the switch 140 is turned off, charging or discharging of the battery module 110 may be stopped. In such examples, the switch 140 may be turned on or off under the control of the BMS 120.

The switch 140 may be implemented as a mechanical relay (e.g., a contactor) that is turned on/off by a magnetic force of a coil, or a semiconductor switch such as a metal oxide semiconductor field effect transistor (MOSFET).

The BMS 120 may monitor a voltage, current, and/or temperature of the battery module 110, calculate a status of charge (SoC) based on a monitoring result, and control charging or discharging.

The BMS 120 may monitor the battery module 110, read a cell voltage, and transmit the cell voltage to other systems connected to the battery module 110.

In addition, the BMS 120 may monitor at least one electrical component that constitutes a battery system and transmit state data thereof to other systems. For this purpose, the BMS 120 may include a communication module for communication with other systems within a device included in the battery system.

The BMS 120 uniformly balances electric charges of the battery module 110 to extend a lifetime (e.g., lifespan) of the battery system.

To perform such operations, the BMS 120 may include various components such as a fuse, a current sensing element, a thermistor, a switch, and a balancer, and in most cases, may additionally include a microcontroller unit (MCU) or a battery monitoring integrated chip (BMIC), which is electrically connected to the components in order to control the components.

A lifetime of a contactor including the switch 140 may vary according to (e.g., based on or depending on) an actual use state of the switch 140. When the lifetime of the contactor ends, a contact point of the contactor may fuse, which may cause a fire, and thus driving problems in electric or hybrid vehicles powered by battery power may occur, which may cause accidents such as human casualties. Therefore, it is desired to predict a lifetime according to the actual use state of the contactor.

Accordingly, the BMS 120 may include a contactor lifetime prediction apparatus that predicts a lifetime of a contactor. The contactor lifetime prediction apparatus may be provided as a component of the BMS 120 and may predict a lifetime of a contactor. In some embodiments, the contactor may correspond to, for example, the switch 140 for controlling charging or discharging of the battery module shown in FIG. 1. However, the contactor is not limited to the switch 140, and a switch element that constitutes the BMS 120 and performs an on/off operation (e.g., a balancing switch or a relay that controls the electrical connection between a battery terminal and the external device 10) may correspond to the contactor. For a further detailed description of a contactor lifetime prediction apparatus 130, reference is made to FIG. 2.

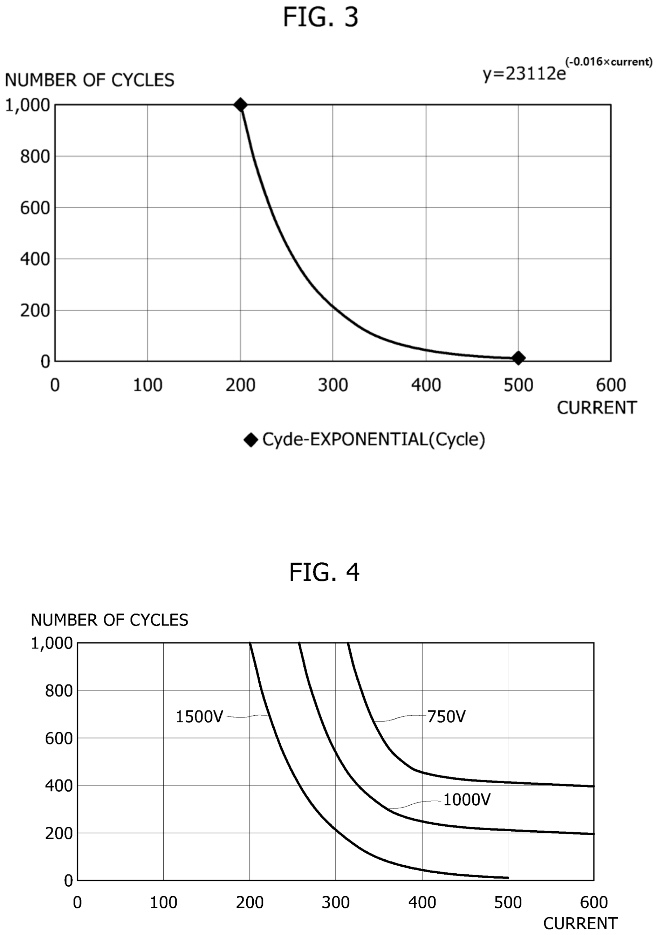

FIG. 2 is a schematic block diagram illustrating a configuration of a contactor lifetime prediction apparatus according to some embodiments of the present disclosure. FIG. 3 is an exemplary graph for describing the number of cycles of a contactor according to a current value according to some embodiments of the present disclosure. FIG. 4 is an exemplary graph for describing the trend of the current number of cycles according to a voltage change according to some embodiments of the present disclosure.

Referring to FIG. 2, a contactor lifetime prediction apparatus 130 according to some embodiments of the present disclosure may include a memory 132, a measurement unit (also referred to as a measurement circuit) 134, an alarm unit (also referred to as an alarm circuit) 136, and a processor 138. Each component 132, 134, or 136 may constitute a BMS 120, and the contactor lifetime prediction apparatus 130 may constitute a battery pack 100 together with a contactor 150 of which a lifetime is to be predicted.

The memory 132 may store at least one instruction executed by the processor 138. In particular, the memory 132 may store an instruction or the like (e.g., program, application, or applet) that enables the number of cycles of the contactor 150 to be calculated when the contactor 150 is turned on or off and enables a lifetime of the contactor 150 to be predicted based on the calculated number of cycles. Pieces of stored information may be selected by the processor 138 as needed. The memory 132 may be implemented as a volatile storage medium and/or a non-volatile storage medium and may be implemented as, for example, a read-only memory (ROM), a random access memory (RAM), a flash memory, or an electrically erasable programmable read-only memory (EEPROM).

The memory 132 may store Underwriter's Laboratories (UL) certification specification information for each contactor 150. Here, the UL certification specification information may include a voltage, a current, the reference number of cycles for each current, a one-time count, and the like during a UL certification test. The reference number of cycles for each current may be the maximum number of cycles that is possible at a corresponding current. The one-time count may be a value counted during one cycle.

For example, UL certification specification information related to contactor A may be as shown in Table 1 below.

**Table 1**

| UL Certification Specification of Contactor A | | |
|---|---|---|
| Voltage | Current | Cycle |
| 1,200 | 80 | 1,000 |
| 1,200 | 150 | 200 |
| | | |

| Current | Reference Number of Cycles | One-Time Count |
|---|---|---|
| 20 | 3,972.4 | 0.076 |
| 30 | 3,156.2 | 0.095 |
| 40 | 2,507.7 | 0.120 |
| 50 | 1,992.4 | 0.151 |
| 60 | 1,583.1 | 0.190 |
| 70 | 1,257.8 | 0.239 |
| 80 | 999.4 | 0.300 |
| 100 | 630.9 | 0.476 |
| 150 | 199.8 | 1.502 |

The measurement unit 134 may measure a current flowing in the contactor 150. As an example, the measurement unit 134 may include a current sensor provided on a line equipped with the contactor 150 and configured to measure a current flowing in the contactor 150.

The alarm unit 136 may be a component that outputs an alarm signal under the control of the processor 138 and may be implemented as, for example, a display device or an audio output device. For example, when the alarm unit 136 is implemented as the display device, the alarm unit 136 may notify a user of the end of a lifetime (e.g., lifespan) of the contactor 150 by displaying an alarm signal on a screen of a monitor or turning a light-emitting element on or off in accordance with the received alarm signal. When the alarm unit 136 is implemented as the audio output device, the alarm unit 136 may notify a user of the end of a lifetime of the contactor 150 by outputting an alarm signal through the audio output device, such as a speaker.

The processor 138 may be a device that predicts a lifetime of the contactor 150, may be implemented as a central processing unit (CPU) or a system-on-chip (SoC), may control a plurality of hardware or software components connected to the processor 138 by running an operating system or application, and may perform processing and calculating on various suitable types of data. The processor 138 may be configured to execute at least one instruction stored in the memory 132 and store execution result data in the memory 132. In particular, in some embodiments, the processor 138 may correspond to an analog front end (AFE) integrated circuit (IC) or an MCU of a BMS.

The processor 138 calculates the number of cycles of the contactor 150 based on a current measured through the measurement unit 134 when the contactor 150 is turned on or off and may predict a lifetime of the contactor 150 by accumulating the calculated number of cycles.

Hereinafter, the operation of predicting, by the processor 138, a lifetime of the contactor 150 will be described in detail.

The processor 138 may control the operation of the contactor 150 according to a BMS control logic predefined (e.g., prestored) in the memory 132. In an example in which the contactor 150 is a charging/discharging switch, the processor 138 may turn the charging/discharging switch off when an overcurrent is detected through a shunt resistor and may turn the charging/discharging switch on when an overcurrent state is released, thereby controlling the on/off operation of the charging/discharging switch according to a typical BMS control logic.

The processor 138 may control the contactor 150 to be turned on or off, thereby recognizing a time point at which the contactor 150 is turned on and a time point at which the contactor 150 is turned off. Accordingly, through the measurement unit 134, the processor 138 may measure a current at the time point at which the contactor 150 is turned on and a current at the time point at which the contactor 150 is turned off. Here, the current at the time point at which the contactor 150 is turned on may refer to a value of a current that flows in the contactor 150 at a moment when the contactor 150 is switched from an off state to an on state. The current at the time point at which the contactor 150 turns off may refer to a value of a current that is flowing in the contactor 150 in an on state immediately before the contactor 150 is turned off.

When a current is measured when the contactor 150 is turned on or off, the processor 138 may calculate the number of cycles of the contactor 150 based on the measured current. Here, the number of cycles of the contactor 150 may be the number of times the contactor 150 is switched on/off, the number of times the contactor 150 is used according to turning-on/off of the contactor 150, or the like.

The processor 138 may calculate the number of cycles of the contactor 150 using an exponential function in which the number of cycles decreases as a current value increases. That is, the processor 138 may calculate the number of cycles of the contactor 150 using Equation 1 below. $Cycle = a \times {e}^{\left(-b\times current\right)}$

Here, the parameters a and b may denote preset values for each type of contactor and each voltage and may be values calculated during a UL certification test. A current may refer to a current value measured at a time point at which the contactor 150 is turned on or off.

A UL certification lifetime (e.g., the number of cycles or the number of times switching is performed) or the ensured number of times switching is performed is set in each contactor 150. When the development, UL certification, or the like of the contactor 150 is performed, a limit test and a lifetime test of the contactor 150 are conducted. The lifetime test of the contactor 150 may be a test in which the number of times switching is performed is obtained as a lifetime of the contactor 150 by performing a repetition test under one voltage/current condition.

For example, when a lifetime test is performed on switch B under a voltage condition of 15,00 V, results as shown in Table 2 below may be obtained.

**Table 2**

| Voltage A | Number of Cycles | One-Time Count |
|---|---|---|
| 20 | 16,782.757 | 0.018 |
| 30 | 14,301.322 | 0.021 |
| 40 | 12,186.783 | 0.025 |
| 50 | 10,384.891 | 0.029 |
| 60 | 8,849.420 | 0.034 |
| 70 | 7,540.979 | 0.040 |
| 80 | 6,425.998 | 0.047 |
| 90 | 5,475.874 | 0.055 |
| 100 | 4,666.232 | 0.064 |
| 150 | 2,096.673 | 0.143 |
| 200 | 942.096 | 0.318 |
| 250 | 423.311 | 0.709 |
| 300 | 190.206 | 1.577 |
| 500 | 7.753 | 38.694 |

When values in Table 2 are represented graphically, the values may be as shown in FIG. 3. Referring to FIG. 3, it can be seen that as a current value decreases, the number of cycles decreases. When the number of cycles is represented by an exponential function in which the number of cycles decreases rapidly as a current value increases, the number of cycles may be represented by Equation 2 below. $Cycle = 23 , 112 \times {e}^{\left(-0.016\times current\right)}$

Referring to Equation 2, it can be seen that the value of the parameter a is 23,112 and the value of the parameter b is 0.016.

When a lifetime test is performed on switch B by changing a voltage condition into 1,000 V and 750 V, a graph shown in FIG. 4 may be obtained. Referring to FIG. 4, it can be seen that a trend is similar even when the voltage condition changes. Thus, it can be seen that although values of the parameters a and b may vary according to types of contactors and voltage conditions, Equation 1 in which the number of cycles decreases rapidly as a current value increases is derived. Therefore, the processor 138 may calculate the number of cycles of the contactor 150 using Equation 1.

When the number of cycles of the contactor at a current time point is calculated, the processor 138 may accumulate the calculated number of cycles to calculate the accumulated number of cycles and may predict a lifetime of the contactor 150 using the accumulated number of cycles. In such examples, the processor 138 may predict the lifetime of the contactor 150 after comparing the accumulated number of cycles with a reference number of cycles (e.g., a preset reference number of cycles). Here, the reference number of cycles may be a reference value that is compared with the accumulated number of cycles and may be the UL certification number of cycles (i.e., a UL certification lifetime or the UL certification number of times switching is performed) or the ensured number of cycles (i.e., the ensured number of times switching is performed) set in the corresponding contactor 150. That is, the reference number of cycles may be a value determined from a profile derived from a UL certification test or the like and may be stored in the memory 132.

The processor 138 may predict the remaining lifetime of the contactor 150 based on a ratio of the accumulated number of cycles to the reference number of cycles. In such examples, the processor 138 may predict the remaining lifetime of the contactor 150 as a percentage (%). For example, when the reference number of cycles is 300 and the accumulated number of cycles is 200, since 67% (=200/300×100%) of the lifespan of the contactor 150 is used, the processor 138 may predict that the remaining lifetime is 33%.

When the lifetime of the contactor 150 ends, a contact point of the contactor 150 may fuse, which may cause a fire, and thus driving problems in electric or hybrid vehicles powered by battery power may occur, which may cause accidents such as human casualties. Therefore, it is desirable to generate an alarm signal before the lifetime of the contactor 150 ends.

Accordingly, the processor 138 may compare the accumulated number of cycles with a threshold number of cycles (e.g., a preset threshold number of cycles), and when the accumulated number of cycles is greater than or equal to the threshold number of cycles according to a comparison result, the processor 138 may output an alarm signal through the alarm unit 136. Here, the critical number of cycles may be an arbitrarily set value that is less than or equal to the reference number of cycles.

Because a lifetime curve of the contactor 150 is an exponential curve, the lifetime curve may have an infinite value when a current continues to increase. When a very large current flows in the contactor 150, a failure or the like may occur in the contactor 150. To solve such a problem, a tolerable maximum allowable current value is set in each contactor 150. Therefore, when a current of the contactor 150 reaches a maximum allowable current value, it is desirable to generate an alarm signal.

Accordingly, the processor 138 may compare a current measured through the measurement unit 134 with a maximum allowable current value (e.g., a preset maximum allowable current value), and when the measured current is greater than or equal to the maximum allowable current value according to a comparison result, the processor 138 may output an alarm signal through the alarm unit 136. In such examples, the processor 138 may compare a current, which is measured through the measurement unit 134 when the contactor 150 is turned off, with the maximum allowable current value.

In this way, by notifying a user of the end of a lifetime of the contactor 150 before a failure of the contactor 150, the processor 138 can prevent or substantially reduce the likelihood of accidents that may occur due to replacement of the contactor 150 or a failure of the contactor 150.

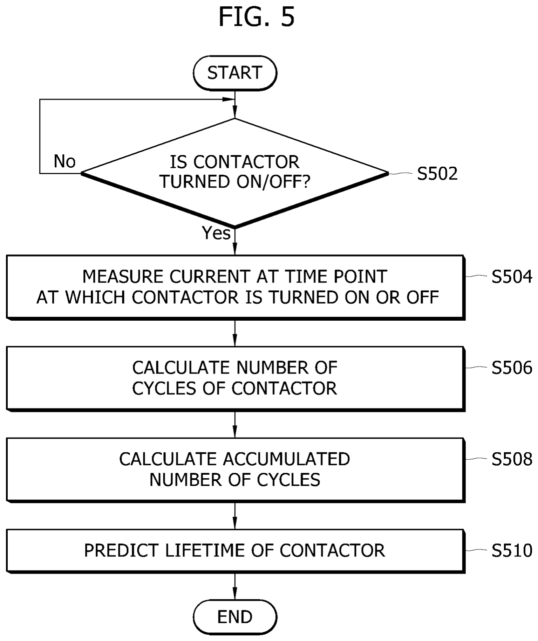

FIG. 5 is a flowchart for describing a contactor lifetime prediction method according to some embodiments of the present disclosure.

Referring to FIG. 5, when the contactor 150 is turned on or off (S502), the processor 138 measures a current at a time point at which the contactor 150 is turned on or off (S504). In such examples, the processor 138 may measure a value of a current flowing in the contactor 150 at a moment when the contactor 150 is switched from an off state to an on state. The processor 138 may measure a value of a current flowing in the contactor 150 in an on state immediately before the contactor 150 is turned off.

When operation S504 is performed, the processor 138 calculates the number of cycles of the contactor 150 based on a measured current (S506). In such examples, the processor 138 may calculate the number of cycles of the contactor 150 using an exponential function in which the number of cycles decreases as a current value increases. That is, the processor 138 may calculate the number of cycles of the contactor 150 using Equation 1 above.

When operation S506 is performed, the processor 138 accumulates the calculated number of cycles to calculate the accumulated number of cycles (S508) and predicts a lifetime of the contactor 150 using the accumulated number of cycles (S510). In such examples, the processor 138 may predict a lifetime of the contactor 150 after comparing the accumulated number of cycles with the reference number of cycles. That is, the processor 138 may predict the remaining lifetime of the contactor 150 based on a ratio of the accumulated number of cycles to the reference number of cycles.

For example, when the reference number of cycles is 300 and the accumulated number of cycles is 200, since 67% of the contactor 150 lifespan is used, the processor 138 may predict that the remaining lifetime is 33%.

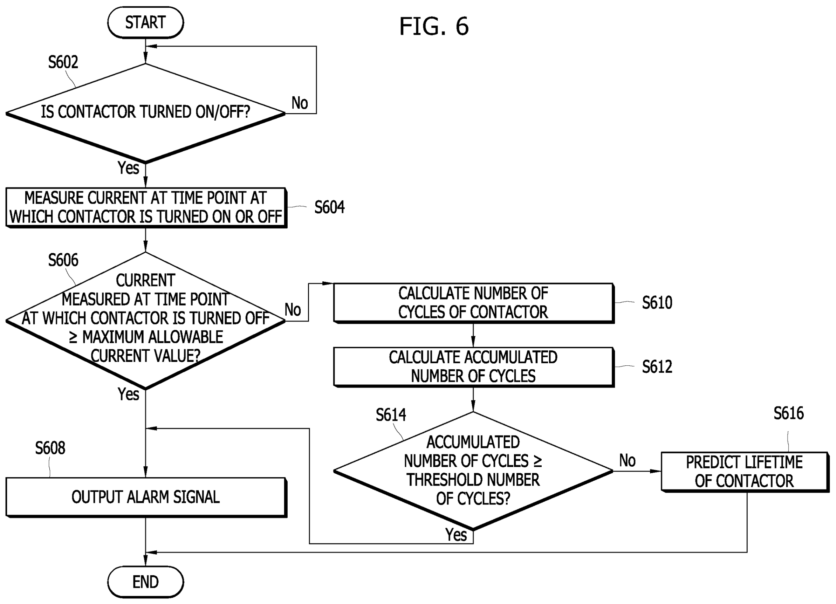

FIG. 6 is a flowchart for describing a contactor lifetime prediction method according to some other embodiments of the present disclosure.

Referring to FIG. 6, when the contactor 150 is turned on or off (S602), the processor 138 measures a current at a time point at which the contactor 150 is turned on or off (S604). In such examples, the processor 138 may measure a value of a current flowing in the contactor 150 at a moment when the contactor 150 is switched from an off state to an on state. The processor 138 may measure a value of a current flowing in the contactor 150 in an on state immediately before the contactor 150 is turned off.

When operation S604 is performed, the processor 138 determines whether the current measured at the time point at which the contactor 150 is turned off is greater than or equal to a maximum allowable current value (S606). When a current with the maximum allowable current value or more flows in the contactor 150, a failure or more may occur in the contactor 150. Therefore, a current with a value that is less than the maximum allowable current value should flow in the contactor 150. Accordingly, the processor 138 may determine whether the current measured at the time point at which the contactor 150 is turned off is greater than or equal to the maximum allowable current value.

When it is determined in operation S606 that the current measured at the time point at which the contactor 150 is turned off is greater than or equal to the maximum allowable current value, the processor 138 outputs an alarm signal through the alarm unit 136 (S608). In such examples, the processor 138 may output the alarm signal using a display device, an audio output device, or the like.

When it is determined in operation S606 that the current measured at the time point at which the contactor 150 is turned off is smaller than the maximum allowable current value, the processor 138 calculates the number of cycles of the contactor 150 based on the measured current (S610). In such examples, the processor 138 may calculate the number of cycles of the contactor 150 using an exponential function in which the number of cycles decreases as a current value increases. That is, the processor 138 may calculate the number of cycles of the contactor 150 using Equation 1 above.

When operation S610 is performed, the processor 138 accumulates the calculated number of cycles to calculate the accumulated number of cycles (S612) and determines whether the calculated accumulated number of cycles is greater than or equal to a threshold number of cycles (S614). When the lifetime of the contactor 150 ends, a contact point of the contactor 150 may fuse, which may cause a fire, and thus driving problems in electric or hybrid vehicles powered by battery power may occur, which may cause accidents such as human casualties. Therefore, it is desirable to generate an alarm signal before the lifetime of the contactor 150 ends. Accordingly, the processor 138 may compare the accumulated number of cycles with the threshold number of cycles.

When it is determined in operation S614 that the accumulated number of cycles is greater than or equal to the threshold number of cycles, the processor 138 performs operation S608.

When it is determined in operation S614 that the cumulative number of cycles is smaller than the critical number of cycles, the processor 138 predicts a lifetime of the contactor 150 using the cumulative number of cycles (S616). In such examples, the processor 138 may predict the lifetime of the contactor 150 after comparing the accumulated number of cycles with a reference number of cycles (e.g., a preset reference number of cycles). That is, the processor 138 may predict the remaining lifetime of the contactor 150 based on a ratio of the accumulated number of cycles to the reference number of cycles.

In this way, according to the present disclosure, by predicting a lifetime of a contactor based on a current measured at a time point at which the contactor is turned on or off, there is an effect of enabling the lifetime of the contactor to be predicted according to an actual use state of the contactor.

According to the present disclosure, an alarm signal is output when a current measured at a time point at which a contactor is turned off is greater than or equal to a maximum allowable current value, thereby preventing or substantially reducing the likelihood of an accident that can occur due to a failure of the contactor.

According to the present disclosure, by outputting an alarm signal when the accumulated number of cycles of a contactor is greater than or equal to the threshold number of cycles, it is possible to notify a user of the end of a lifetime of the contactor before the contactor fails, thereby preventing or substantially reducing the likelihood of accidents that may occur due to replacement of the contactor or a failure of the contactor.

However, effects that can be achieved through the present disclosure are not limited to the above-described effects and other effects that are not described may be clearly understood by those skilled in the art from the detailed descriptions.

The embodiments described herein may be implemented, for example, as a method or process, a device, a software program, a data stream, or a signal. Although discussed in the context of a single type of implementation (e.g., discussed only as a method), features discussed herein may also be implemented in other forms (e.g., a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto.

## Claims

1. A contactor lifetime prediction apparatus (130) comprising:
a measurement circuit configured to measure a current flowing in a contactor (150); and
a processor (138) configured to calculate a number of cycles of the contactor (150) based on the current measured by the measurement circuit when the contactor (150) is turned on or off, to accumulate the calculated number of cycles, and to predict a lifetime of the contactor (150).

2. The contactor lifetime prediction apparatus (130) of claim 1, wherein the processor (138) is configured to calculate the number of cycles of the contactor (150) using an exponential function in which the number of cycles decreases as a current value increases.

3. The contactor lifetime prediction apparatus (130) of claim 1 or 2, wherein the processor (138) is configured to predict the lifetime of the contactor (150) after comparing the accumulated number of cycles with a reference number of cycles.

4. The contactor lifetime prediction apparatus (130) of claim 3, wherein the processor (138) is configured to calculate a percentage of a ratio of the accumulated number of cycles to the reference number of cycles, and to predict that a remaining lifetime of the contactor (150) is a remaining percentage relative to the calculated percentage.

5. The contactor lifetime prediction apparatus (130) of any one of the preceding claims, further comprising an alarm circuit,
wherein, in response to the accumulated number of cycles being greater than or equal to a threshold number of cycles, the processor (138) is configured to output an alarm signal through the alarm circuit.

6. The contactor lifetime prediction apparatus (130) of any one of the preceding claims,
wherein in response to the current measured through the measurement circuit at a time point at which the contactor (150) is turned off being greater than or equal to a maximum allowable current value, the processor (138) is configured to output the alarm signal through the alarm circuit.

7. A contactor lifetime prediction method comprising:
measuring (S504), by a processor (138), a current flowing in a contactor (150) when the contactor (150) is turned on or off;
calculating (S506), by the processor (138), a number of cycles of the contactor (150) based on the measured current; and
accumulating (S508), by the processor (138), the calculated number of cycles and predicting a lifetime of the contactor (150).

8. The contactor lifetime prediction method of claim 7, wherein, in the calculating of the number of cycles of the contactor (150), the processor (138) is configured to calculate the number of cycles of the contactor (150) using an exponential function in which the number of cycles decreases as a current value increases.

9. The contactor lifetime prediction method of claim 7 or 8, wherein, in the predicting of the lifetime of the contactor (150), the processor (138) is configured to compare the accumulated number of cycles with a threshold number of cycles and to predict the lifetime of the contactor (150) or to output an alarm signal according to a comparison result.

10. The contactor lifetime prediction method of claim 9, wherein, in the predicting of the lifetime of the contactor (150), in response to the accumulated number of cycles is smaller than the threshold number of cycles, the processor (138) is configured to predict the lifetime of the contactor (150) after comparing the accumulated number of cycles with a reference number of cycles.

11. The contactor lifetime prediction method of claim 10, wherein, in the predicting of the lifetime of the contactor (150), the processor (138) is configured to calculate a percentage of a ratio of the accumulated number of cycles to the reference number of cycles, and to predict that a remaining lifetime of the contactor (150) is a remaining percentage relative to the calculated percentage.

12. The contactor lifetime prediction method of any one of the claims 9 to 11, wherein, in the predicting of the lifetime of the contactor (150), in response to the accumulated number of cycles being greater than or equal to the threshold number of cycles, the processor (138) is configured to output the alarm signal.

13. The contactor lifetime prediction method of any one of the claims 7 to 12, wherein, in the calculating of the number of cycles of the contactor (150), the processor (138) is configured to compare the current, which is measured at a time point at which the contactor (150) is turned off, with a maximum allowable current value and to calculate the number of cycles of the contactor (150) or to output an alarm signal based on a comparison result.

14. The contactor lifetime prediction method of claim 13, wherein, in the calculating of the number of cycles of the contactor (150), the processor (138) is configured to calculate the number of cycles of the contactor (150) based on the measured current in response to the current measured at the time point at which the contactor (150) is turned off being smaller than the maximum allowable current value, and to output the alarm signal in response to the current measured at the time point at which the contactor (150) is turned off being greater than or equal to the maximum allowable current value.

15. A battery pack (100) comprising:
a plurality of battery modules (110);
a contactor (150) directly or indirectly connected to the plurality of battery modules (110); and
a battery management system, BMS (120), configured to control an on/off operation of the contactor (150) and to predict a lifetime of the contactor (150) based on a current measured at a time point at which the contactor (150) is turned on or off;
a contactor lifetime prediction apparatus (130) of any one of the claims 1 to 6.
